# EUROPEAN PATENT APPLICATION

(11) **EP 4 542 645 A1**
(43) Date of publication of application: **23.04.2025**
(21) Application number: 23204877.7
(22) Date of filing: 20.10.2023
(51) Int. Cl.: H01L 23/495, H01L 23/00, H01L 21/48

(54) **A METHOD OF MANUFACTURING SEMICONDUCTOR ASSEMBLIES**

(71) Applicant: Nexperia B.V., 6534 AB Nijmegen (NL)
(72) Inventor: Dimaano Jr, Antonio B., Singapore (SG); Tan, Wei Leong, Wuxi (CN)
(74) Representative: Pjanovic, Ilija

(57) **Abstract**

There is disclosed a method of manufacturing a semiconductor device. The method comprises securing a die to a die paddle with solder and securing a clip to the die with solder to form a first subassembly. The method further comprises heating the first subassembly to at least the melting temperature of the solder, then subsequently removing at least some of the solder from the die paddle in a region adjacent the die to expose the die paddle in that region. The method further comprises moulding a casing on to the first subassembly such that the casing at least partly surrounds the die, the die paddle, and the clip.

## Description

### Field of Invention

The present invention relates to a method of manufacturing a semi-conductor device.

### Background

Semiconductor assemblies, such as transistors, are manufactured as layered assemblies including components such as die paddles, dies, clips and a casing. The casing provides a protective functionality and at least partially surrounds the die and other components that form a part of the semiconductor assembly.

Semiconductor assemblies are manufactured by bonding the components together. Once bonded, the assembly defines a laminate structure that forms a number of layers. For example, the die paddle, die(s), clip(s), and casing may each form a layer of the laminate structure.

Semi-conductor assemblies are subject to stress in use. The stress may arise as a result of, for example, thermal expansion of the components and/or mechanical deformation. The stress to which semi-conductor assemblies are subject to can result in delamination of the components. This is undesirable because delamination can ultimately lead to failure of the assembly as a result of, for example, moisture ingress.

There exists a need to overcome the disadvantages associated with existing methods of manufacturing semiconductor assemblies, whether mentioned in this document or otherwise.

### Summary

In a first aspect of the invention there is provided a method of manufacturing a semiconductor device. The method comprises securing a die to a die paddle with solder and securing a clip to the die with solder to form a first subassembly. The method further comprises heating the first subassembly to at least the melting temperature of the solder, then subsequently removing at least some of the solder from the die paddle in a region adjacent the die to expose the die paddle in that region. The method further comprises moulding a casing on to the first subassembly such that the casing at least partly surrounds the die, the die paddle, and the clip.

Removing at least some of the solder from the die paddle in a region adjacent the die may be understood to refer to removing solder from the die paddle in a region that, when the first subassembly is viewed in plan view (i.e., perpendicular to a first major surface of the die paddle), is adjacent and outboard of the footprint of the die.

Solder may be removed from the die paddle in a region that is adjacent and outboard of the footprint of the die.

Solder is typically used in semiconductor devices to secure the components of the devices together. Liquid (molten) solder is applied to the die paddle in the region to which the die is to be secured, and the die is placed on the liquid solder to create a temporary joint. The components are then heated to a temperature above the melting temperature of the solder in a process referred to as reflow, which creates a permanent joint. During reflow, some of the solder can spread beyond the footprint of the die, covering a part of the die paddle. Following reflow, a casing, which is typically an epoxy mould compound, is moulded onto the components.

The solder spreading beyond the footprint of the die is undesirable because the strength of the bond between the casing and the solder is less than the strength of the bond between the casing and the die paddle. Reduced bond strength increases the likelihood of delamination of the casing from the other components of the device, which ultimately leads to failure of the device due to, for example, moisture ingress. By removing at least some of the solder from the die paddle in a region adjacent the die, the strength of the bond between the casing and the first subassembly is improved. Advantageously, this reduces the likelihood of delamination of the components.

The region of the die paddle that is exposed by removal of the solder may correspond to the region from which solder was removed.

The solder may be removed from the die paddle using laser ablation.

Laser ablation allows removal of the solder in an efficient manner.

The method may further comprise, while removing at least some of the solder from the die paddle, removing at least some material from the die paddle to form a groove in the die paddle.

Where a groove is formed in the die paddle, the surface area of the die paddle is increased. Increasing the surface area of the die paddle improves the bond strength between the casing and the die paddle. In addition, the groove acts as a locking mechanism to better secure the casing to the die paddle. Therefore, the groove further reduces the likelihood of delamination of the device.

The groove may extend around at least 50% of the perimeter of the die paddle.

The groove may extend around at least 25% of the perimeter of the die paddle.

The groove extending around the perimeter of the die paddle may be understood to mean that the groove extends inboard of a periphery of the die paddle.

The groove may extend around at least 50% of the footprint of the die. The groove may extend around at least 25% of the footprint of the die.

Where the groove extends around at least 50% of the perimeter of the die paddle, the likelihood of delamination is reduced to a desirable amount.

The groove may define a plurality of sections that each define a continuous path or a discontinuous path.

The sections of the groove defining a respective continuous path may be understood to mean that the each section does not define any vertices. A vertex may be defined at the interfaces between the sections of the groove. In some embodiments, one or more of the sections may define vertices.

A discontinuity in the groove presents a delamination risk because stress can concentrate at the discontinuity. Therefore, where the groove sections define a continuous path, the likelihood of delamination of the components is further reduced.

The groove may be non-linear. The groove may define a wave formation.

Where the groove is non-linear, the length, and therefore surface area, of the groove is increased as compared to if, for example, the groove were linear. Increasing the surface area of the groove increases the surface area of the die paddle, thereby increasing the bond strength between the casing and the die paddle. Increasing the bond strength between the casing and the die paddle advantageously reduces the likelihood of delamination of the device.

Moulding the casing on to the first subassembly may comprise moulding the casing into the groove.

The groove depth and/or width may be at least 5µm. The groove depth and/or width may be at least 3µm and/or up to 15µm. The width of the groove may be at least 20µm and/or up to 40µm. The depth of the groove may be up to 10µm.

The method may further comprise, prior to removing at least some of the solder from the die paddle, applying a protective layer to the first subassembly.

Where a protective film is applied to the first subassembly, the likelihood of damage to the components of the device while removing the solder from the die paddle is reduced.

The method may further comprise after heating the first subassembly and before removing at least some of the solder from the die paddle, applying a protective layer to the first subassembly. The solder may be removed by chemical etching.

A ratio of an area of a footprint of the die to an area of the footprint of the die paddle may be at least 0.75.

A ratio of an area of a footprint of the die to an area of the footprint of the die paddle may be at least 0.5.

The area of the footprint of the die may refer to the total footprint area of the die. The area of the footprint of the die paddle may refer to the total footprint area of the die paddle.

A larger die to paddle ratio increases the likelihood of delamination because the solder can spread to a periphery of the die paddle, leaving no or very little die paddle material for the casing to bond to. Therefore, the present invention is particularly beneficial where a ratio of a cross-sectional area of the die, taken in a plane parallel to a major surface of the die, to a cross-sectional area of the die paddle, taken in a plane parallel to a major surface of the die paddle is at least 0.75. Having a larger die to paddle ratio allows for increased functionality of the device as compared to a smaller die to paddle ratio.

### Brief Description of the Drawings

Embodiments of the present application will now be described with reference to the accompanying figures, in which:
Figure 1 shows a cross-sectional side view of a semi-conductor device manufactured according to an embodiment of the present invention;
Figures 2 to 7 schematically show a method of manufacturing the semi-conductor device of Figure 1 according to an embodiment of the present invention;
Figure 8 shows a first subassembly of the semi-conductor device of Figure 1; and
Figure 9 shows a further step in the method of manufacturing the semi-conductor device of Figure 1.

### Detailed Description

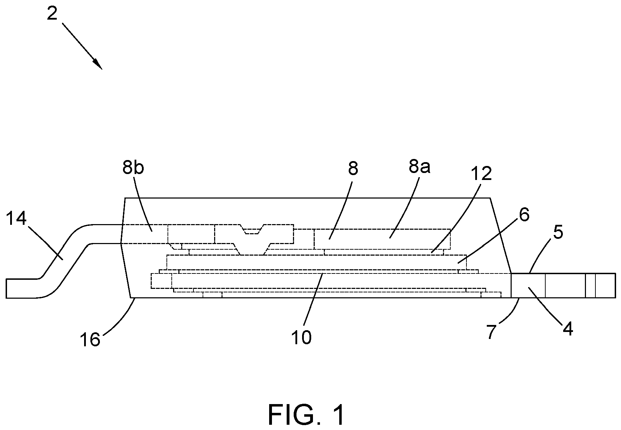

Figure 1 shows a semiconductor device 2. The semi-conductor device 2 comprises a die paddle 4. The semi-conductor device 2 comprises a die 6. The semi-conductor device 2 comprises a clip 8.

The die paddle 4 serves as a base of the semi-conductor device 2 to which other components of the device are attached. The die paddle 4 defines a first major surface 5 and a second major surface 7. The second major surface 7 is generally opposed to the first major surface 5. The die paddle 4 is a generally plate-like component, and is generally quadrangular. The die paddle 4 forms a base in the manufacture of the device 2. The die paddle 4 is manufactured from a conductive material such as copper (including a copper alloy).

The die 6 is secured to the die paddle 4. The die 6 is secured to the die paddle 4 by virtue of a first solder layer 10. Although not apparent from Figure 1, the die 6 comprises multiple constituent components (only one of which is visible in Figure 1 - the others are hidden by the visible component). However, in some embodiment, the die 6 may comprise a single component. The die 6 is made of a semi-conducting material. The die 6 has a functional circuit fabricated thereon. The die 6 is generally rectangular but may be any other suitable shape. The die 6 is plate-like in shape.

The clip 8 is formed of multiple constituent parts 8a, 8b. Each part 8a, 8b of the clip 8 is secured to a respective component of the die 6. The clip 8 is secured to the die 6 by virtue of a second solder layer 12. The second solder layer 12 may be applied in multiple sections, each for a respective component of the die 6, as will be discussed in more detail below. A plurality of leads 14 (only one of which is visible in Figure 1 - the rest are hidden by the lead that is visible) extend from the clip 8. Each part 8a, 8b of the clip 8 may have at least one lead 14. The plurality of leads 14 may be integrally formed with the respective part 8a, 8b of the clip 8, or may be separately formed from the clip 8 and secured to the respective part of the clip 8 using any suitable method, such as by welding.

The semi-conductor device 2 further comprises a cover 16. The cover 16 may also be referred to as an isolator, a casing, or an encapsulant. The cover 16 encapsulates the remaining components of the semi-conductor device 2 (i.e., the die paddle 4, the die 6, and the clip 8). The cover 16 adheres to the die paddle 4, the die 6, and the clip 8, which secures the cover 16 thereto. However, as will be discussed in more detail below, the cover 16 can separate from the components in use due to, for example, repeated deformation of the device 2. The leads 14 of the clip 8 extend through the cover 16. This allows the leads 14, and therefore the device 2, to be connected to the external circuit (not shown). The cover 16 may be made from any suitable electrically isolating material, such as an epoxy.

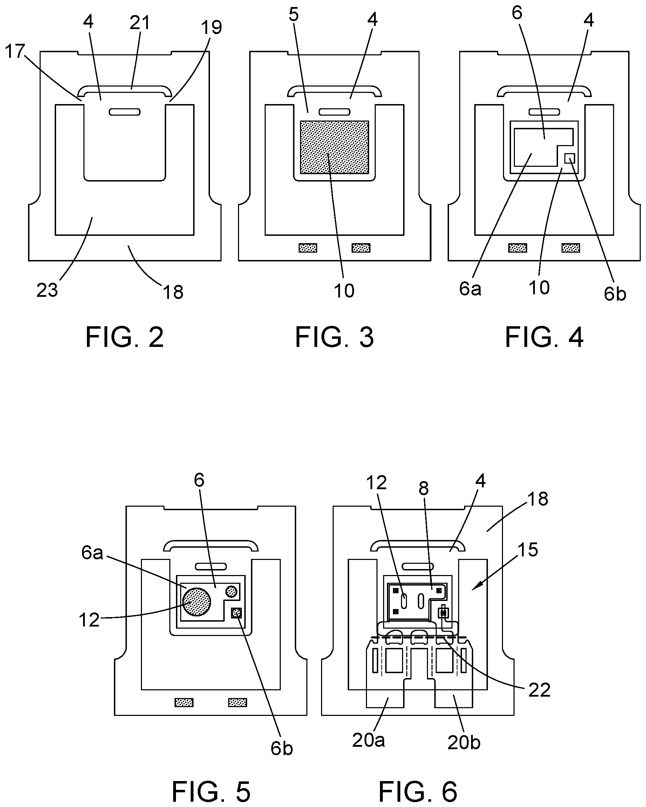

Manufacture of the semi-conductor device 2 will now be discussed with reference to Figures 2 to 11.

Beginning with Figure 2, the die paddle 4 is shown in a form where it is still connected to a surrounding frame 18. The frame 18 may be referred to as a lead frame. The frame 18 is effectively a planar plate of conductive material, such as copper, from which the geometry of the die paddle 4 is stamped or etched. As such, as shown in Figure 3, the closed shapes labelled 21 and 23 are openings in the frame 18 which are not full of material (i.e. they are voids). As shown in Figure 2, the die paddle 4 is only attached to the surrounding frame 18 by virtue of branches 17, 19. The branches 17, 19 could otherwise be described as attachment points where the die paddle 4 is attached to the frame 18. The frame 18 may comprise an array of, for example, 20 x 5 die paddles (e.g. for a batch production process).

Turning to Figure 3, a subsequent step of the manufacture process is schematically indicated. In the step shown in Figure 3, the first solder layer 10 is printed or dispensed onto the die paddle 4. In particular, the first solder layer 10 is printed or dispensed onto the first major surface 5 of the die paddle 4. In a subsequent step shown in Figure 4, first and second components 6a, 6b of the die 6 are attached to the die paddle 4 by virtue of the first solder layer 10. This step may therefore be described as coupling the die 6 to the die paddle 4 with solder.

In the subsequent step shown in Figure 5, the second solder layer 12 is dispensed or printed onto the die 6, specifically onto first and second components 6a, 6b.

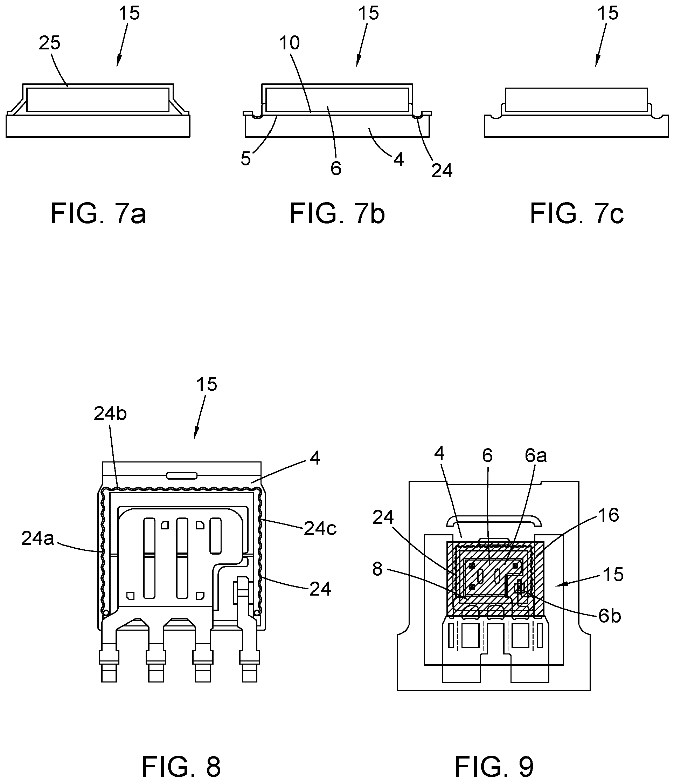

In the subsequent manufacture step shown in Figure 6, the clip 8 is coupled to the die (not visible in Figure 6, it is behind the clip) by virtue of the second solder layer 12. This step may therefore be described as coupling the clip 8 to the die 6 with solder. Once the clip 8 is coupled to the die, a first subassembly 15 is formed. The first subassembly 15 comprising the die paddle 4, the die, the clip 8, and the first and second solder layers 10, 12. The clip 8 is initially attached to a larger strip of copper, in a similar manner to the frame 18, but is detached from said strip in advance of being attached to the die paddle 4 in the illustrated embodiment. The clip 8 may be said to be attached to a top of the die 6. The bottom of the die 6 may be said to be attached to the die paddle 4. The clip 8 is also attached to the surrounding frame 18 at points 20a, 20b. In a later step of the process (i.e. after Figure 9), the clip 8 is cut across line 22 to isolate the clip 8 from the frame 18 and define the plurality of leads 14 of the clip 8.

For completeness, although the illustrated embodiment comprises the clip 8, the clip 8 is not an essential feature of the invention. In other embodiments, wirebonding may instead be used to couple a connector to the die. The connector may comprise one or more external leads. However, using the clip is preferable because the clip has desirable conductivity characteristics.

In a subsequent step, not shown, the first subassembly 15 is heated. The process of heating the first subassembly 15 may be referred to as reflow. When undergoing reflow the first subassembly 15 is heated to a temperature that is greater than or equal to the melting temperature of the first and second solder layers 10, 12. Put another way, the first subassembly 15 is heated to a temperature that is at least equal to the melting temperature of the solder (of the first and second solder layers 10, 12). This causes the first solder layer 10 and the second solder layer 12 to melt. Melting of the first and second solder layers 10, 12 can cause one or both of the first and second solder layers 10, 12 to spread. In some instances, the first solder layer 10 may spread beyond the footprint of the die 6. The footprint of the die 6 may be understood to refer to the area that is bounded by the periphery of the die 6 when the first subassembly 15 is viewed in plan view (i.e., from above). Spreading of the first solder layer 10 may result in a limited area of the first major surface 5 of the die paddle 4 being exposed. This is because a large part of the first major surface 5 of the die paddle 4 may be covered by the first solder layer 10. The bond strength between the casing 16 and the die paddle 4 is proportion to the amount of the first major surface 5 of the die paddle 4 that is exposed. Where none, or a small amount, of the first major surface 5 of the die paddle 4 is exposed, the bond strength between the cover 16 and the die paddle 4 is reduced as compared to where a larger area of the first major surface 5 is exposed. This can result in separation of the cover 16 from the die paddle 4 in use. The present invention seeks to address this issue, as will be discussed in more detail below.

In a subsequent step, shown in Figure 7a, a protective layer 25 is applied to the first sub assembly 15. The protective layer 25 may be a protective material, such as a protective film. The protective layer 25 may be made of a highly purified water-soluble protective material, such as a water-soluble film. The protective layer 25 covers at least the top surfaces (when viewed in plan view) of the first sub assembly 15. The protective layer is preferably water soluble. The protective layer 25 being water soluble advantageously allows easy removal of the protective layer 25 in a later step.

In a subsequent step, shown in Figures 7b and 7c, at least some of the solder of the first solder layer 10 is removed from the first sub assembly 15. In particular at least some of the first solder layer 10 is removed from the die paddle 4 in a region adjacent the die 6. Removal of at least some of the solder of the first solder layer 10 from the die paddle 4 in a region adjacent the die 6 exposes the die paddle 4 in that region. The solder of the first solder layer 10 is removed using laser ablation. Removing at least some of the solder from the first solder layer 10 from the die paddle 4 in a region adjacent the die 6 may be understood to refer to removing solder of the first solder layer 10 from the die paddle 4 in a region that, when the first subassembly 15 is viewed in plan view (i.e. perpendicular to the first major surface of the die paddle 4), is adjacent and outboard of the footprint of the die 6. The bond strength between the casing (not shown in Figures 7b and 7c - it has not yet been moulded on to the first subassembly) and the die paddle 4 is greater than the bond strength between the casing and the first solder layer 10. Therefore, exposing the die paddle 4 increases the bond strength between the casing and the first subassembly 15, which reduces the likelihood of delamination of the device 2.

The laser ablation may also remove some of the material from the die paddle 4. Removal of the material from the die paddle 4 results in the formation of a groove 24 in the die paddle 4. The groove 24 can be seen in Figure 7b. The groove 24 further increases the bond strength between the cover 16 and the die paddle 4. This is because the surface area of the first major surface 5 of the die paddle 4 is increased by the presence of the groove 24. In some embodiments, the groove 24 may extend around at least 50% of the footprint, or periphery, of the die 6. However, in some embodiments, the groove 24 may extend around less than 50% of the footprint, or periphery, of the die 6. The groove 24 extends about a perimeter of the die paddle 4. In some embodiments, the groove may extend about at least 50% of the perimeter of the die paddle 4. The groove 24 extending about a perimeter of the die paddle 4 may be understood to mean that the groove 24 is disposed inboard of the periphery of the die paddle 4. The groove 24 may be said to be disposed in the region, when the first subassembly 15 is viewed in plan view (i.e, perpendicular to the firs major surface 5 of the die paddle 4), which is between the periphery of the footprint of the die 6 and the periphery of the footprint of the die paddle 4. The depth and/or width of the groove 24 may be at least 5µm. In some embodiments, the depth and/or width may be at least 3µm and/or up to 15µm. The width of the groove 24 may be at least 20µm. In some embodiments, the depth of the groove may be up to 10µm. In some embodiments, the width of the groove 24 may be up to 40µm. In some embodiments, the width of the groove 24 may be greater than 40µm. The width and/or depth of the groove 24 may be chosen based on, for example, the size of the semiconductor device 2, and the intended application of the semi-conductor device 2.

Referring to Figure 8, the first subassembly 15 is shown in plan view following formation of the groove 24. The groove 24 define a plurality of sections 24a-c. In the depicted embodiment, the plurality of sections 24a-c comprises three sections. However, in some, non-depicted, embodiments, the groove 24 may define any suitable number of sections. The number of sections of the groove may be determined by, for example, the geometry of the die paddle 4, the die 6. For example, the groove may define only a single section, or may define four or more sections. The sections 24a-c define a respective continuous path. The sections 24a-c of the groove 24 defining a respective continuous path may be understood to mean that each section 24a-c does not define any vertices. The sections 24a-c may extend continuously from one another. This may be understood to mean that no vertices are defined at the interfaces between the sections 24a-c of the groove 24. However, in some embodiments, one or more vertices may be defined at the interface between the sections 24a-c of the groove 24. In the embodiment shown in Figure 8, each section of the groove 24 is non-linear. In particular, each section 24a-c of the groove 24 defines a wave formation. This further assists with the strength of the bond between the die paddle 4 and the cover (not shown in Figure 8, it has not yet been moulded onto the first subassembly 15). This is because the surface area of the groove 24 is increased where it is non-linear, as compared to if the groove were, for example, linear. In other embodiments, the groove 24 may define any other suitable non-linear or linear formation. In some embodiments, the sections 24a-c may not be continuous. For example, one or more of the sections 24a-c of the groove 24 may be dashed, may define a zig-zag formation, or may be formed of a plurality of dots. In some embodiments, a groove need not be provided, and the laser ablation may be carried out to only remove solder from the first solder layer 10. That is to say, the laser ablation does not remove any material from the die paddle 4.

In a subsequent step, shown in Figure 7c, the first sub assembly 15 is washed. The step of washing the first subassembly 15 may be referred to as 'flux cleaning', or simply 'cleaning process'. The first subassembly 15 may be washed using water. Since the protective layer 25 is water soluble, washing the first subassembly 15 with water dissolves the protective layer. In other embodiments, the protective layer 25 may not be water soluble, and the first subassembly may be washed using an alternative substance. Washing the first subassembly 15 also removes any residue that may be present on the first subassembly 15 following the laser ablation.

In a subsequent step shown in Figure 9, a casing 16 is moulded onto the first subassembly 15 such that the casing at least partly surrounds the die 6, the die paddle 4, and the clip 8. The casing 16 does not entirely surround all of these components, but should surround at least the exposed surfaces of the die 6 (i.e., of all components 6a, 6b of the die). The casing 16 may therefore be said to surround the die and at least part of the die paddle 4 and the clip 8. The extent to which the casing 16 covers the first subassembly 15 is indicated by the hatched markings shown in Figure 9. Also, the casing 16 is shown in a partially transparent view so as to aid the understanding of the location of the casing 16. The purpose of the casing 16 is to protect the die from moisture ingress and impacts.

The casing 16 is overmoulded to the die paddle 4 by injection moulding a casing material which is able to flow. The material flows through a mould, not shown in Figure 9, which defines the shape of the casing 16 once the material has set (e.g. hardened, or solidified). The material flows to surround the first subassembly 15, as discussed above. The material also flows into the groove 24. As such, the groove 24 defines a locking feature into which material can extend to more robustly couple the casing 16 to the die paddle 4. This reduces the risk of the casing 16 delaminating and/or cracking.

In a subsequent step of manufacture, which is not shown in Figures 2 to 11, the first subassembly 15 is detached from the surrounding frame 18 by cutting the branches 17, 19 shown in Figure 2. During the cutting process, the leads 14 of the clip 8 are also cut and formed. Assembly of the semiconductor assembly is therefore complete.

In some, non-depicted, embodiments, the solder may be removed using chemical etching instead of laser ablation. Where chemical etching is used, the method is the same as for the previous embodiment up to the reflow step. Following reflow, a protective layer is applied to the first subassembly 15. The protective layer is applied to the surfaces that no chemical etching is to take place on. Therefore, the protective layer may be applied to all visible surfaces of the first subassembly 15 excluding the first solder layer 15 in the region between the periphery of the footprint of the die 6 and the periphery of the die paddle 4. Following this, the first subassembly is submerged in a chemical bath. The chemical bath may contain a chemical capable of dissolving solder. For example, the chemical contained in the bath may be an aqueous solution of 0.3M fluroboric acid with 0.2M hydrogen peroxide. The first subassembly is submerged for a predetermined amount of time. The predetermined amount of time may be, for example, at least 5 minutes and/or up to 20 minutes. Following elapse of the predetermined amount of time, the first subassembly 15 is removed from the chemical bath. The first subassembly 15 is then washed. Submersion in the chemical bath removes solder from the die paddle in a region adjacent the die, preferably adjacent the footprint of the die, to expose the die paddle. This allows the casing 16 to better adhere to the first subassembly 15. The casing 16 is then applied in the same manner as discussed above in relation to Figure 9.

Removal of the solder from the die paddle 4, whether by laser ablation or chemical etching, advantageously improves adhesion between the casing 16 and the first subassembly 15, in particular the casing 16 and the die paddle 4. As mentioned above, this is because the bond strength between the casing 16 and the die paddle 4 is greater than the bond strength between the casing 16 and the solder material. It may be particularly desirable to increase the bond strength between the casing 16 and the first subassembly 15, in particular the die paddle 4, where a ratio of the area of the footprint of the die 6 to the area of the footprint of the die paddle 6, also referred to as the D/P ratio, is at least 0.75. A higher D/P ratio may be required depending upon the required functionality of the semi-conductor device 2. However, a higher D/P ratio reduces the area of the die paddle 4 to which the casing 16 is able to adhere, said area being further reduced by solder spread. Therefore, removing solder from the first subassembly is particularly advantageous where the D/P ratio is at least 0.75.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of manufacturing a semiconductor device, the method comprising:
securing a die to a die paddle with solder and securing a clip to the die with solder to form a first subassembly;
heating the first subassembly to at least the melting temperature of the solder, then subsequently removing at least some of the solder from the die paddle in a region adjacent the die to expose the die paddle in that region; and
moulding a casing on to the first subassembly such that the casing at least partly surrounds the die, the die paddle, and the clip.

2. The method of claim 1, wherein the solder is removed from the die paddle using laser ablation.

3. The method of claim 2, further comprising, while removing at least some of the solder from the die paddle, removing at least some material from the die paddle to form a groove in the die paddle.

4. The method of claim 3, wherein the groove extends around at least 50% of the perimeter of the die paddle.

5. The method of claim 3 or claim 4, wherein the groove defines a plurality of sections that each define a continuous path or a discontinuous path.

6. The method of any of claims 3 to 5, wherein the groove is non-linear; optionally wherein the groove defines a wave formation.

7. The method of any of claims 3 to 6, wherein moulding the casing on to the first subassembly comprises moulding the casing into the groove.

8. The method of any of claims 4 to 7, wherein the groove depth and/or width is at least 5µm.

9. The method of any preceding claim, further comprising, prior to removing at least some of the solder from the die paddle, applying a protective layer to the first subassembly.

10. The method of claim 1 or claim 2, further comprising, after heating the first subassembly and before removing at least some of the solder from the die paddle, applying a protective layer to the first subassembly, and wherein the solder is removed by chemical etching.

11. The method of any preceding claim, wherein a ratio of an area of a footprint of the die to an area of the footprint of the die paddle is at least 0.75.
